**Europäisches Patentamt**

**European Patent Office**

**Office européen des brevets**

(11) Numéro de publication : **0 509 875 A1**

# (12) DEMANDE DE BREVET EUROPEEN

(21) Numéro de dépôt : **92400941.8**

(22) Date de dépôt : **03.04.92**

(51) Int. Cl.$^5$ : **C23C 16/26**

Une requête visant à ajouter une planche de dessin a été présentée conformément à la règle 88 CBE. Il est statué sur cette requête au cours de la procédure engagée devant la division d'examen (Directives relatives à l'examen pratiqué à l'OEB, A-V, 2.2).

(30) Priorité : **19.04.91 FR 9104896**
**22.10.91 FR 9113017**

(43) Date de publication de la demande :
**21.10.92 Bulletin 92/43**

(84) Etats contractants désignés :
**AT BE CH DE DK ES FR GB GR IT LI LU NL PT SE**

(71) Demandeur : **Société dite CARBIONIC SYSTEME**
**2, rue de l'Epinette**
**Saint Soupplets (Seine & Marne) (FR)**

(72) Inventeur : **Fieffe-Prevost, Patrick Jacques**
**8, rue Weber**
**F-75116 Paris (FR)**
Inventeur : **Neuville, Stéphane**
**22 Allée de la Rouvraie**
**F-78480 Verneuil sur Seine (FR)**
Inventeur : **Jacques, Claude Fernand**
**23 Résidence des Tilleuls**
**F-77340 Pontault Combault (Seine&Marne) (FR)**
Inventeur : **Garnier, Jean Michel Bernard**
**2, rue Charles Péguy**
**F-77500 Chelles (Seine & Marne) (FR)**
Inventeur : **Bollore, Michel Yves**
**5, Rue du Conseiller Collignon**
**F-75116 Paris (FR)**

(74) Mandataire : **Cabinet Pierre HERRBURGER**
**115, Boulevard Haussmann**
**F-75008 Paris (FR)**

(54) **Procédé pour le dépôt sur au moins une pièce, notamment une pièce métallique, d'une couche dure à base de pseudo carbone diamant ainsi que pièce revêtue d'une telle couche.**

(57) a) Procédé pour le dépôt sur au moins une pièce, notamment une pièce métallique, d'une couche dure à base de carbone diamant amorphe ainsi que pièce revêtue d'une telle couche.

b) Procédé caractérisé en ce que l'on ajoute au gaz carboné, en tant qu'agent dopant d'une part, jusqu'à 70 % de composés siliciés, notamment de silane et/ou de tétraméthylsilane, et, d'autre part, 1 à 30 % de composés renfermant au moins un atome voisin du carbone dans la classification de MENDELEIEV.

EP 0 509 875 A1

La présente invention se rapporte à un procédé pour le dépôt sur au moins une pièce, notamment une pièce métallique, d'une couche dure à base de carbone diamant amorphe par la technique dite "CVD assisté plasma" dans le but d'améliorer ses propriétés surfaciques, notamment d'augmenter sa résistance à l'usure par frottement, ou sa résistance à l'abrasion, ou encore la protéger contre la corrosion.

Pour remédier aux problèmes de corrosion et d'usure, on a cherché, depuis plusieurs décennies, à revêtir la surface des pièces métalliques, notamment de celles appelées à subir de fortes contraintes, de couches de protection parmi lesquelles on peut à titre d'exemple mentionner les couches de type TiN ou celles obtenues par nitruration.

Malgré leur qualité intrinsèque, de telles couches ne se sont pas toujours montrées aptes à donner entière satisfaction, particulièrement dans le cas de pièces destinées à résister à des sollicitations très élevées, notamment pièces de moules, pièces d'usure mécanique, etc ...

Pour résoudre ces problèmes, les chercheurs ont proposé, il y a quelques années, des revêtements dits de "pseudo carbone diamant" ayant une structure hybride, c'est-à-dire intermédiaire entre le graphite et le diamant qui est souvent schématisée par la formule a - C : H. Cette abréviation signifie que le matériau a une structure amorphe du point de vue de l'observation avec un microscope à balayage et qu'il contient surtout du carbone avec une proportion d'hydrogène non précisée.

De manière plus précise, la structure de ces couches de pseudo carbone diamant n'est pas totalement amorphe : des méthodes d'analyse plus pointues montrent en effet que la structure est pour 1/3 comparable à celle du graphite et pour 2/3 comparable à celle du diamant. Il en résulte de nombreuses propriétés particulièrement intéressantes qui ont déjà été étudiées dans la littérature.

De tels dépôts peuvent être obtenus par la mise en oeuvre de différentes techniques dont celle qui est actuellement la plus couramment utilisée, est connue sous la dénomination "CVD assisté plasma", CVD signifiant Chemical Vapour Deposition, c'est-à-dire condensation de vapeur par voie chimique.

Dans la technique CVD classique, on introduit un mélange de gaz dans une enceinte dans laquelle se trouvent les pièces à revêtir que l'on élève à une température de l'ordre de 800 à 1500°C. A ces températures, les gaz introduits peuvent réagir chimiquement les uns avec les autres et conduire à la formation d'une couche mince solide qui se condense sur les pièces chaudes.

Cette technique ne peut être utilisée que pour des matériaux durs ou des céramiques susceptibles de résister à des températures de 800 à 1500°C ; pour généraliser son utilisation, les spécialistes ont mis au point la technique dite "CVD assisté plasma" dans laquelle la température peut s'abaisser à 200, voire à 60°C dans certains cas particuliers.

Un réacteur adapté à la technique "CVD assisté plasma" est à titre d'exemple représenté en annexe. Ce réacteur est principalement constitué par une chambre 1 que l'on peut fermer de façon hermétique et à l'intérieur de laquelle on peut réaliser un vide à l'aide de pompes 2. Les pièces 3, que l'on souhaite revêtir, sont posées sur un support métallique 4 (cathode porte-substrats) qui est relié à un générateur de courant 5, le cas échéant à travers un isolant étanche 6. Les gaz 7 peuvent être introduits dans l'enceinte 1 par l'intermédiaire de vannes doseuses 8 alors que les pompes 2 sont en fonctionnement. Le volume de plasma est entouré d'une zone appelée "gaine" 9 à travers laquelle les ions sont accélérés (physique des plasmas).

Pour déposer des couches en pseudo carbone diamant, on utilise classiquement des gaz carbonés contenant notamment un ou plusieurs hydrocarbures, le plus souvent, du méthane, de l'acétylène, du propane ou du butane ; on peut, le cas échéant, leur ajouter de l'hydrogène ou des gaz rares notamment de l'argon.

Lorsque les vannes 8, permettant l'introduction du gaz carboné 7, sont fermées, on obtient dans la chambre 1, au moyen des pompes 2, un vide de l'ordre de $10^{-5}$ mb après quelques minutes. On ouvre les vannes 8 jusqu'à ce que la pression atteigne une valeur de l'ordre de $10^{-3}$ à 1 mb. Le générateur 5 est habituellement constitué par un générateur haute fréquence qui travaille dans un domaine de fréquence de 2 à 20 MHz de façon à apporter l'énergie nécessaire à l'entretien d'une décharge électrique. La température des pièces à revêtir 3 est alors portée à une valeur de l'ordre de 100 à 200°C.

Dans des conditions requises de pression et de puissance électrique, on peut exciter chimiquement et physiquement le gaz carboné et le ioniser de sorte que les atomes perdent partiellement leurs électrons en se transformant en particules positives : on est alors en présence d'un plasma qui se reconnaît à sa lueur spécifique. Cette transformation a pour corollaire un "craquage" du mélange gazeux en hydrogène et en carbone solide qui se dépose sur la pièce à revêtir ; en moyenne, le carbone contient encore de 10 à 40 % d'hydrogène, ce qui signifie que, sur 3 à 5 atomes de carbone, on trouve dans la couche mince un atome d'hydrogène.

Parallèlement à la transformation susmentionnée en plasma du gaz carboné introduit primitivement, le support métallique se charge lui-même négativement tout comme la pièce à revêtir, qui exerce par suite une force d'attraction sur les ions positifs présents dans le plasma ; ceux-ci sont donc accélérés en direction de la pièce. En conséquence, le dépôt de pseudo carbone diamant est soumis à un bombardement d'ions pendant sa croissance.

Ce bombardement est un facteur très important qui a plusieurs fonctions :

- au point d'impact de chaque ion, les atomes présents dans le revêtement en formation sont soumis à des chocs importants. Dans une sphère qui a pour centre le point d'impact, les atomes sont soumis à des pressions très fortes qui les compriment avant d'être relaxées, ce qui produit une élévation de température très courte de l'ordre de plusieurs milliers de °C.

- l'inertie (l'énergie du choc ionique) peut être telle que certaines particules moins solidement liées peuvent se détacher de la couche mince en formation ; ce processus est nommé pulvérisation cathodique.

La première des fonctions décrites ci-dessus produit localement, dans des volumes microscopiques, des conditions comparables par exemple à celles de la synthèse du diamant. La seconde fonction est comparable à la sélection naturelle dans la nature : seules les liaisons chimiques les plus solides sont maintenues, les liaisons les plus faibles étant éliminées par la pulvérisation cathodique.

Le processus susmentionné permet d'obtenir le dépôt d'une couche mince d'un matériau particulièrement dur et dense.

De tels revêtements protecteurs en pseudo carbone diamant peuvent être utilisés dans de nombreux domaines de l'industrie parmi lesquels on peut noter, à titre d'exemple, la construction mécanique, hydraulique, pneumatique, les techniques de peinture, l'outillage, la transformation des matières plastiques, les techniques du vide, l'optique, les techniques sanitaires, le textile, la chimie, la médecine et la décoration.

Le coût unitaire de ces processus peut être considérablement diminué par la possibilité de traiter simultanément une série de pièces.

Outre leur dureté, de l'ordre d'environ 3 000 HV à 6 000 HV, ces revêtements présentent l'avantage d'avoir un très faible coefficient de frottement vis-à-vis des métaux (meilleur que celui du téflon), de garantir une bonne protection contre la corrosion, et de pouvoir être fabriqués à des températures inférieures à 200°C (alors que le nitrure de titane exige des températures de 4 à 500°C).

Ces revêtements présentent toutefois un certain nombre de défauts parmi lesquels on peut noter leur instabilité thermique à des températures supérieures à 400/500°C, ainsi que leur faible adhérence et leur fragilité induisant notamment des risques d'écaillement, ainsi qu'une usure souvent trop rapide.

De nombreux chercheurs travaillent actuellement dans le domaine des couches dures à base de pseudo carbone diamant pour tenter de remédier aux inconvénients susmentionnés.

On a dans ce but déjà proposé des revêtements dits de pseudo carbone diamant modifié obtenus en incorporant des dopants dans le mélange carboné préalablement introduit dans la chambre à vide, notamment des composés siliciés (Document DE 38 38 905). On s'est ainsi rendu compte qu'une addition de silicium permet d'améliorer l'adhérence des couches de pseudo carbone diamant sur leur substrat ; de telles couches présentent, toutefois, l'inconvénient d'être nettement moins dures que celles qui sont exemptes de silicium (environ 1000 HV de moins) ce qui correspond à un grave inconvénient étant donné que les dépôts ainsi obtenus se rayent beaucoup plus facilement et s'usent plus rapidement, ce qui limite leur durée de vie en frottement ou en abrasion, et en particulier les rend inaptes pour de nombreuses utilisations.

On a également proposé d'incorporer au mélange carboné des dopants autres, notamment des composés fluorés de façon à modifier les propriétés anti-adhérentes des pièces revêtues et à obtenir un mouillage moins prononcé des pâtes et liquides.

On n'a toutefois pas encore pu résoudre dans leur totalité les défauts susmentionnés des revêtements de pseudo carbone diamant.

La présente invention a pour objet de remédier à cet inconvénient en proposant un procédé pour le dépôt sur au moins une pièce, notamment métallique, d'une couche dure de carbone diamant amorphe par la technique dite "CVD assisté plasma" de façon à augmenter sa résistance à l'usure par frottement, diminuer les phénomènes de frottement en particulier lorsque les surfaces frottantes ne sont pas ou mal lubrifiées, augmenter la résistance à l'abrasion, diminuer l'adhérence vis-à-vis de produits organiques comme les plastiques et les caoutchoucs, ou assurer sa protection contre la corrosion et ce tout en maintenant sa température pendant le procédé à moins de 200°C pour éviter les déformations et l'altération de la dureté du substrat sous-jacent, et en conservant une ductilité de plus de 50 %, notamment de plus de 80 %.

L'invention, conformément à ce procédé, consiste à introduire un gaz carboné contenant notamment un ou plusieurs hydrocarbures dans une chambre à vide renfermant un support métallique relié à un générateur de courant et sur lequel se trouve la ou les pièce (s) à revêtir, et à entretenir une décharge électrique à l'intérieur de la chambre de façon à élever la température de la pièce à une valeur de l'ordre de 100 à 200°C et dans des conditions de puissance et de pression permettant l'excitation physique et chimique du gaz et son ionisation de façon à provoquer le dépôt sur la pièce d'une couche dure à base de pseudo carbone diamant.

Ce procédé est caractérisé en ce que l'on ajoute au gaz carboné en tant qu'agent dopant, d'une part, jusqu'à 70 % de composés siliciés, notamment de silane et/ou de tétraméthylsilane, et, d'autre part, 1 à 30 % de composés renfermant au moins un atome voisin du carbone dans la classification de MENDELEIEV.

Comme il a été indiqué ci-dessus, il est également possible de combiner aux composés siliciés 1 à 25 % de substance fluorée notamment fluorocarbonée, le cas échéant sous forme de $CF_4$ ou de $C_2F_8$.

L'idée à la base de l'invention consiste cependant à associer au silicium un dopant autre de nature à libérer dans la chambre à vide, en cours de processus, des ions de taille voisine du carbone susceptibles de s'insérer à l'intérieur de sa maille de manière à y introduire des dislocations qui augmentent sensiblement la dureté de la couche finale obtenue.

Les dopants pouvant être ainsi utilisés conformément à l'invention sont le bore et l'azote, c'est-à-dire les deux atomes entourant directement le carbone dans la classification, le premier étant un peu plus petit tandis que le second est un peu plus grand.

L'expérience a montré que l'on peut avantageusement ajouter au gaz carboné 1 à 15 % de composés azotés, notamment sous forme de $NO_2$, $NH_3$ ou composés volatils carbonitrurés et/ou 1 à 50 % de composés borés, notamment sous forme de $B(CH_3)$ ou $B_2H_6$, l'halogénure de bore ou encore de composés organométalliques. Bien entendu, les espèces chimiques susmentionnées ne sont indiquées qu'à titre d'exemple et ne sauraient en aucune manière être considérées comme étant limitatives de l'invention.

La caractéristique préférentielle de l'invention consiste toutefois à combiner au silicium, à la fois des composés azotés et des composés borés, ce qui, en raison des dimensions respectives de ces deux éléments par rapport au carbone permet de compenser le défaut de la maille ainsi introduit, et donc de limiter les tensions internes, de sorte que les couches dures finalement obtenues ont une moins forte tendance à l'écaillement.

Il convient d'insister sur le fait qu'une telle addition est totalement différente des alliages de nitrure de bore qui appartiennent à la famille des céramiques.

On obtient ainsi une meilleure adhérence et une meilleure solidité et il est par suite possible de prévoir des couches plus épaisses.

Il est à noter que, dans le but d'augmenter la stabilité thermique des couches de pseudo carbone diamant, on avait déjà tenté, dans le passé, de leur incorporer de l'azote. Ces tentatives se sont toutefois avérées insuffisantes étant donné que les couches ainsi obtenues se sont toujours distinguées par un défaut d'adhérence et une relative fragilité les rendant inaptes aux applications industrielles.

Or, l'association des différents dopants prévus conformément à l'invention, dans laquelle le silicium apporte la souplesse et l'adhérence, tandis que l'azote et le bore amènent la stabilité thermique augmente la dureté de manière surprenante. Il est ainsi possible d'augmenter la dureté de l'ordre de 700 à 3000 HV et d'obtenir des propriétés nouvelles de résistance à l'abrasion utilisables de façon pratique, c'est-à-dire de disposer d'une adhérence et d'une résistance aux pressions de Hertz et aux chocs suffisantes, et ce tout en préservant les propriétés tribologiques connues (de l'ordre de 0,02 à 0,1).

Selon une variante de l'invention on s'est rendu compte de manière surprenante que si l'on choisissait d'une part en tant que dopant des molécules carbonées borées et azotées particulières et d'autre part en tant que gaz carboné au moins un hydrocarbure en $C_6$ à $C_8$ on pouvait obtenir des couches satisfaisantes à la fois dures et adhérentes et ce sans adjonction de silicium.

Cette possibilité est basée sur l'utilisation dans la composition du gaz carboné, d'hydrocarbures durs mais volatils, dont la molécule présente un nombre d'atomes de carbone relativement élevé, ce qui permet d'augmenter la vitesse du dépôt tout en limitant les contraintes mécaniques.

Les hydrocarbures le plus couramment utilisés sont l'heptane et l'octane qui présentent l'avantage d'être particulièrement peu onéreux ; il est, cependant, également possible de mettre en oeuvre des hydrocarbures présentant un certain pourcentage d'insaturation qui permettent d'augmenter notablement la vitesse de dépôt.

L'utilisation des hydrocarbures susmentionnés a permis d'augmenter les vitesses de dépôt jusqu'à des valeurs de l'ordre de 8 µm par heure, alors qu'avec les procédés habituels, il était très difficile d'atteindre 5 µm par heure.

L'expérience a montré que conformément à cette variante de l'invention pour obtenir l'effet désiré, il est impératif d'ajouter aux hydrocarbures, à la fois, des atomes de bore et des atomes d'azote.

Il s'est, en particulier, avéré avantageux de choisir en tant que dopant une molécule carbonée borée et azotée ayant le même nombre d'atomes d'azote et d'atomes de bore.

Il est cependant difficile de maintenir la stoechiométrie si ce n'est en mettant en oeuvre en tant qu'agent dopant une molécule carbonée ayant le même nombre d'atomes d'azote et d'atomes de bore.

La proportion relative C/N + B peut largement varier en fonction du résultat recherché, étant entendu que plus la proportion d'éléments dopants est élevée, plus la couche obtenue est dure, mais moins bonnes sont ses qualités du point de vue de la tribologie.

L'agent dopant, proprement dit, peut être quelconque sans pour cela sortir du cadre de l'invention ; l'expérience a cependant démontré que l'on pouvait utiliser, avantageusement, le borane dimétylalamine qui comporte 4 atomes de carbone, 1 atome d'azote et 1 atome de bore ; compte tenu de la faible tension de vapeur de ce composé, il est cependant nécessaire de chauffer celui-ci à 50 à 100°C pour obtenir une quantité de vapeur suffisante, et ce, en prenant les précautions d'usage étant donné son caractère inflammable et explosif.

D'autres composés contenant la même quantité d'azote et de bore tels que la borazine ou d'autres borures azotés peuvent bien entendu être mis en oeuvre.

Un autre avantage d'une telle association du bore et de l'azote réside dans le fait que les couches ainsi obtenues ont un pouvoir "mouillant" moindre vis-à-vis des lubrifiants qui s'étalent moins facilement que sur des couches ne comportant pas d'agent dopant ; cette caractéristique permet de conserver, en présence de lubrifiant, les coefficients de frottement que l'on obtient à sec, ce qui est de la plus grande importance lorsque le procédé conforme à l'invention est utilisé pour le revêtement de pièces de moteur : en effet, en l'absence d'agent dopant, le coefficient de frottement tombe à une valeur de l'ordre de 0,05 au lieu de 0,15.

Conformément à l'invention, le gaz carboné contenant les agents dopants est dans tous les cas introduit dans la chambre à vide à une pression environ comprise entre $5 \, 10^{-3}$ et $8 \, 10^{-2}$ mb et la puissance développée par le générateur de courant est ajustée pour obtenir une tension de décharge de l'ordre de 100 à 1000 V.

On a pu prouver que le procédé selon l'invention permet, pour un résultat identique d'abaisser la tension de travail. On a, ainsi, pu obtenir en travaillant à des tensions de l'ordre de 3 à 400 V et à des températures inférieures à 200°C un dépôt de carbone diamant amorphe dont la dureté, mesurée avec un appareil de micro-dureté du type Fisher est de 35 000 à 45 0000 $N/mm^2$, mesurée à 5 mN soit 4 000 à 6 000 HV ayant une souplesse de 40 à 90 % et adhérant parfaitement sur toutes les surfaces susceptibles de constituer des carbures ou des liaisons carbonées stables en surface.

Par ailleurs, l'addition de bore et d'azote permet, grâce aux dislocations qu'elle induit dans la structure carbo-hydrogénée des couches, de rendre celles-ci légèrement conductrices.

Il est à noter que, selon l'invention, la couche en carbone diamant amorphe peut être déposée directement sur la pièce, ou sur une sous-couche d'adhérence, le plus souvent isolante, auquel cas il est bien entendu indispensable de mettre en oeuvre un générateur haute-fréquence.

Une telle sous-couche peut être constituée par une couche riche en silicium notamment déposée en utilisant le réacteur permettant la mise en oeuvre du procédé selon l'invention ; dans ce cas, on utilise, en tant que gaz réactionnel, un composé riche en silicium tel que notamment du silane ou autre composé carboné. Une telle couche en silicium présente l'avantage de bien adhérer sur le substrat grâce à la bonne affinité du silicium pour l'oxygène et à la stabilité de l'oxyde $SiO_2$.

On peut également prévoir de déposer, par voie électrolytique, une couche de nickel qui présente la particularité d'avoir une bonne adhérence, en particulier dans le cas de substrats creux.

Par ailleurs, dans l'art antérieur de la technique CVD assisté plasma traditionnelle il est d'usage de prévoir une étape préliminaire de "décapage" de la surface de la pièce à traiter avec de l'argon à une pression de l'ordre de $10^{-2}$ mb, pendant une durée qui est en général de l'ordre de 10 à 20 minutes, afin d'éliminer par pulvérisation les oxydes résiduels de surface.

Il est bien entendu possible, conformément à l'invention, de prévoir un tel traitement préliminaire. On s'est toutefois rendu compte qu'il est particulièrement avantageux de remplacer, lors de ce traitement, l'argon par le krypton, voire d'ajouter au gaz carboné mis en oeuvre dans la phase de dépôt proprement dite 5 à 30 % de krypton dans le but d'obtenir un bombardement plus puissant. La masse atomique plus élevée du krypton assure en effet, d'une part, un compactage plus important de la couche de carbone diamant amorphe en cours de dépôt, et, d'autre part, permet une meilleure sélection naturelle des liaisons plus solides entre atomes de carbone déposés en éliminant de préférence, par pulvérisation, les liaisons plus faibles, conférant ainsi au matériau des propriétés de dureté accrues.

Indépendamment de ce qui précède, l'expérience a permis de constater que les dépôts à base de carbone diamant amorphe, et même ceux présentant une forte teneur en silicium s'accrochent mal sur des aciers et métaux tels qu'inox, nickel, chrome contenant du carbone ; on peut à titre d'exemple noter l'acier chrome carbone contenant 17 % de chrome et 2 % de carbone, sur lequel les dépôts de carbone diamant amorphe s'accrochent mal et ce en dépit d'une dépassivation chimique et ionique préalable par décapage et réduction de l'oxyde notamment par de l'argon.

Ce phénomène est dû au fait que, dans les aciers contenant beaucoup de carbone dissout, le carbone présent en surface accapare les orbitales électroniques des métaux et que par suite les atomes de carbone des couches de carbone diamant amorphe ne peuvent en surface trouver suffisamment d'atomes de métal non réduits pour assurer une bonne adhérence.

Dans certains cas comme le TiC ou le WC, le métal dispose toujours d'une affinité résiduelle pour un carbone supplémentaire et le problème de l'adhérence se pose moins.

On connaît déjà un procédé pour durcir les aciers et les rendre glissants par nitruration consistant à employer l'azote dans un plasma à $10^{-1}/10^{-3}$ mbar, 500/1000 V ; l'azote peut alors former des groupes cyanurés CN très stables et réduire le carbone allié dans les aciers. L'emploi d'azote dans les gaz utilisés pour le dépôt de couches dures à base de pseudo carbone diamant ne convient cependant pas pour la constitution des premières mono-couches d'adhérence car il réduit les atomes de carbone incidents et les groupements azotés n'adhèrent pas sur le substrat.

Conformément à une autre caractéristique de l'invention, on a mis au point un procédé apte à résoudre ce problème.

Celui-ci est caractérisé en ce que, préalablement au dépôt de la couche dure à base de pseudo carbone diamant, on fait subir à la pièce un traitement préalable de nitruration par lequel on désoxyde la surface à traiter pendant environ 5 à 10 mn à 5 $10^{-2}$/ $10^{-3}$ mbar à 500/1000 V avec un gaz rare, notamment de l'argon, puis on nitrure la surface et les sous-couches de la pièce pendant 5 à 30 mn à 500/1000 V.

La durée du procédé dépend de la profondeur de la sous-couche que l'on veut durcir parallèlement.

L'invention permet donc de disposer sur l'alliage, d'une surface métallique propre mais sur laquelle les atomes de carbone sont réduits (neutralisés) par l'azote qui se trouve en dessous des couches atomiques de surface.

Dans le cas particulier des outils de coupe, les essais CETIM ont montré que l'adjonction d'azote dans le carbone diamant amorphe, le rendait plus stable en température (600/700°C) et permettait de rendre compatible ces revêtements avec la coupe des aciers. Le problème est que pour la couche d'adhérence, on ne peut employer l'azote.

On constate en effet un très bon comportement de coupe avec une usure très faible qui se dégrade brutalement au bout d'un fonctionnement prolongé, donc après dégradation thermique de la couche d'adhérence.

A très grande vitesse de fraisage (70 mètres par mn sur acier à 90 kilogrammes, coupe très sévère) on constate que les outils de coupe non nitrurés ont des durées de vie comparables au TiCN par rattrapage de l'usure en fin ce cycle.

L'emploi du procédé susmentionné conforme à l'invention a pour avantage :

- de durcir les sous-couches, ce qui est très important pour augmenter la résistance à la fatigue de l'ensemble couche/sous-couche et d'augmenter la résistance de l'arête de coupe après usure du revêtement.

- d'améliorer l'adhérence, la fiabilité et la reproductibilité du procédé de préparation.

- à titre de référence, il est ainsi possible de déposer une couche de pseudo carbone diamant de 10 µm à 5000 HV sans que la couche éclate, alors que sinon les dépôts éclatent à partir de 4 - 5 µm.

- de permettre la diffusion de l'azote dans la couche d'adhérence après élévation de température et de stabiliser thermiquement la couche d'adhérence, ce qui permet de prolonger notablement la durée de vie de l'outil de coupe par rapport au TiCN et de bénéficier des avantages en définition de coupe et en frottement plus faible pour l'évacuation du copeau.

Pour les couteaux tranchants l'arête de coupe se déforme et s'aplatit et le dépôt finit par éclater sur les parties latérales de l'arête déformée. Le procédé susmentionné de prénitruration permet d'augmenter la dureté de l'arête du substrat et d'augmenter l'adhérence du dépôt.

Il permet également de déposer des couches de carbone diamant amorphe sur des couches de nickel ou de chrome avec brillanteur.

Il permet également le dépôt de couches de pseudo carbone diamant sur des moules qui ont déjà servi pour le moulage de plastique et caoutchouc (mise au point du moule avant le revêtement).

Par ailleurs, et pour certaines utilisations particulières, il est nécessaire de pouvoir disposer de couches de revêtement à la fois très dures et adhérentes, mais qui parallèlement présentent un bon degré de transparence dans le visible.

Les dépôts de pseudo carbone diamant produits à faible tension de polarisation (100/500 V) sont connus pour être moins durs et plus transparents dans le visible que les dépôts à plus haute énergie, mais ils présentent deux inconvénients :

- ces dépôts se craquellent et ne forment pas de couches continues,

- ces dépôts sont très lents, car pour travailler avec des tensions d'auto-polarisation faibles, on obtient en général des densités de plasmas plus faibles.

L'utilisation des plasmas micro-ondes permet d'augmenter la densité des plasmas sans augmenter la tension d'auto-polarisation, mais le premier inconvénient subsiste.

L'introduction d'azote dans du tétraméthylsilicium permet de stabiliser la couche et d'obtenir des couches transparentes de faibles épaisseurs de l'ordre de 1000 Å. Compte tenu de la moindre dureté (1 500 HV à 2 000 HV) il faut néanmoins envisager des épaisseurs plus grandes (5 000 à 10 000 Å au lieu de 1 000). La durée du procédé devient alors beaucoup plus longue, et donc celui-ci devient plus onéreux ; de plus les couches font apparaître une coloration jaune résiduelle.

Selon une autre caractéristique de l'invention on se propose également de supprimer cette coloration.

A cet effet, on ajoute au gaz carboné de l'azote imprégnée de borane préalablement obtenu en faisant barboter de l'azote dans un réservoir de borane triethylamine de façon à obtenir des couches totalement transparentes dans le visible.

En faisant barboter l'azote dans un réservoir de borane triethylamine dont la tension de vapeur est très faible, on peut, en effet, doper les couches avec du bore en très faible concentration, de l'ordre de 1‰ de borure par rapport au composé carbone/silicium/azote.

On a pu vérifier dans ce cas, en travaillant à des tensions d'auto-polarisation de l'ordre de 80 à 100 V, que la coloration résiduelle disparaît et que la vitesse de dépôt augmente ; on peut ainsi obtenir des couches totalement transparentes dans le visible, ayant une épaisseur de 0,5 μm en 3/4 d'heure.

Un tel procédé est particulièrement intéressant pour effectuer des dépôts sur des verres de lunettes organiques qui ont besoin d'une faible charge thermique, ou encore sur une optique en verre, pour la protéger contre le brouillard salin et les rayures.

Il convient également de noter que l'on peut combiner un dépôt transparent avec le procédé susmentionné permettant d'augmenter la dureté et l'adhérence dans le domaine de la bijouterie, notamment pour munir des pièces en or de revêtements durs aptes à les protéger contre les rayures et le ternissement.

L'invention se rapporte également à des pièces, notamment des pièces métalliques, revêtues d'une couche dure à base de carbone diamant amorphe appliquée par la mise en oeuvre du procédé susmentionné.

Parmi les domaines d'utilisation du procédé conforme à l'invention, on peut, à titre d'exemple non limitatif, mentionner les possibilités suivantes :

- revêtement d'outils de coupe destinés au travail de l'aluminium, du titane et des aciers de dureté courante.
- revêtement d'outils de découpe en carbure de tungstène et carbure de tungstène-cobalt ainsi que de lames de coupe.
- revêtement de la visserie pour la protection contre la corrosion dans les carlingues d'avion.
- traitement des chemises, pistons, poussoirs, cames, tiges de soupapes, segments dans les moteurs à explosion, axes de pistons, alésages de bielles.
- revêtement de pièces d'usure et de frottement dans des systèmes hydrauliques : gaine, pistons.
- revêtement d'engrenages à sec.
- revêtement de pièces de frottement dans les transmissions mécaniques.
- revêtement de sièges, paliers, pistons, clapets de systèmes de vérins hydrauliques pour la protection contre l'usure et la corrosion.
- revêtement de moules pour le plastique, caoutchouc, aluminium, ... contre l'abrasion, la corrosion, pour faciliter le démoulage et le coulissement de pièces mécaniques.
- Il est à noter que l'on utilise actuellement des moules en acier et non en aluminium considérés comme trop fragiles (abrasion facile). La mise en oeuvre du procédé conforme à l'invention permet le remplacement de ces moules par des moules en aluminium revêtus d'une couche dure à base de pseudo carbone diamant, ce qui permet d'abaisser le prix de revient de 50 à 70 %.
- revêtement d'objets électroménagers tels que poêles, casseroles, couteaux, de façon à obtenir un revêtement non rayable et à permettre une cuisine sans huile.
- revêtement d'articulations spatiales réutilisables devant fonctionner jusqu'à 1000°C en l'absence de lubrifiant.
- revêtement anti-corrosion et anti-abrasion des aubes de turbines et compresseurs.
- revêtement anti-usure isolant.

## Revendications

**1°)** Procédé pour le dépôt sur au moins une pièce, notamment une pièce métallique, d'une couche dure à base de carbone diamant amorphe par la technique dite "CVD assisté plasma" par laquelle on introduit un gaz carboné contenant notamment un ou plusieurs hydrocarbures dans une chambre à vide renfermant un support métallique relié à un générateur de courant et sur lequel se trouve la pièce à revêtir, et on entretient une décharge électrique à l'intérieur de la chambre de façon à élever la température de la pièce à une valeur de l'ordre de 100 à 120°C et dans des conditions de puissance et de pression permettant l'excitation physique et chimique du gaz et son ionisation de façon à provoquer le dépôt sur la pièce d'une couche dure à base de carbone diamant amorphe, procédé caractérisé en ce que l'on ajoute au gaz carboné en tant qu'agent dopant, d'une part, jusqu'à 70 % de composés siliciés, notamment de silane et/ou de tétraméthylsilane, et, d'autre part, 1 à 30 % de composés renfermant au moins un atome voisin du carbone dans la classification de MENDELEIEV.

**2°)** Procédé selon la revendication 1, caractérisé en ce que l'on ajoute au gaz carboné 1 à 15 % de composés azotés notamment sous forme de $NO_2$, $NH_3$ ou de composés volatils carbonitrurés.

**3°)** Procédé selon l'une quelconque des revendications 1 et 2, caractérisé en ce que l'on ajoute au gaz carboné 1 à 50 % de composés borés notamment sous forme de $B(CH_3)_3$, d'halogénure de bore ou encore de composés organo-métalliques.

**4°)** Procédé selon l'une quelconque des revendications 1 à 3, caractérisé en ce que l'on ajoute au gaz carboné 1 à 25 % de substances fluorocarbonées, notamment sous forme de $CF_4$ ou de $C_2F_8$.

**5°)** Procédé selon la revendication 1 caractérisé en ce que le gaz carboné est constitué par au moins un hydrocarbure en $C_6$ à $C_8$ et est associé à un agent dopant, lui même constitué par une molécule carbonée borée et azotée notamment ayant le même nombre d'atomes d'azote et d'atomes de bore.

**6°)** Procédé selon la revendication 5, caractérisé en ce que le gaz carboné comprend entre 10 et 50 % d'agent dopant.

**7°)** Procédé selon l'une quelconque des revendications 5 et 6, caractérisé en ce que l'agent dopant est le borane diméthylalamine.

**8°)** Procédé selon l'une quelconque des revendications 1 à 7, caractérisé en ce que l'on ajoute au gaz carboné 5 à 30 % de krypton.

9°) Procédé selon l'une quelconque des revendications 1 à 8, caractérisé en ce que l'on introduit le gaz carboné dans la chambre à vide à une pression environ comprise entre $8 \cdot 10^{-3}$ et $5 \cdot 10^{-2}$ mbar en ajustant la puissance pour obtenir une tension de décharge de l'ordre de 100 à 2000 volts.

10°) Procédé selon l'une quelconque des revendications 1 à 9, caractérisé en ce que préalablement à l'introduction du gaz carboné on nettoie la surface de la pièce par bombardement de krypton à une pression d'environ $10^{-2}$ mbar et pendant 10 à 20 mn.

11°) Procédé selon l'une quelconque des revendications 1 à 10, caractérisé en ce que l'on dépose sur la pièce une sous-couche d'adhérence riche en silicium.

12°) Procédé selon l'une quelconque des revendications 1 à 11, caractérisé en ce que, préalablement au dépôt de la couche dure à base de carbone diamant amorphe, on fait subir à la pièce un traitement préalable de nitruration par lequel on désoxyde la surface à traiter pendant environ 5 à 10 mn à $5 \cdot 10^{-2}/5 \cdot 10^{-3}$ mbar à 500/1000 V avec un gaz rare notamment de l'argon, puis on nitrure la surface et les sous couches de la pièce pendant 5 à 30 mn à 500/1000 V.

13°) Procédé selon l'une quelconque des revendications 1 à 12, caractérisé en ce que l'on ajoute au gaz carboné de l'azote imprégnée de borane préalablement obtenue en faisant barboter de l'azote dans un réservoir de borane-triethylamine de façon à obtenir des couches totalement transparentes dans le visible.

14°) Pièce, notamment pièce métallique, caractérisée en ce qu'elle est revêtue d'une couche dure à base de carbone diamant amorphe appliquée par la mise en oeuvre du procédé selon l'une quelconque des revendications 1 à 13.

Office européen
des brevets

**RAPPORT DE RECHERCHE EUROPEENNE**

Numero de la demande

EP    92 40 0941
Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 395 198 (DIGITAL EQUIPMENT CORP.)<br><br>* page 9, ligne 1 - page 10, ligne 28 *<br>--- | 1,3,4,8,9,14 | C23C16/26 |
| A | EP-A-0 264 505 (CANON K.K.)<br>* page 44, ligne 1 - ligne 27 *<br>--- | 1,3,14 | |
| A | JOURNAL OF MATERIAL SCIENCE LETTERS<br>vol. 5, no. 10, Octobre 1986, LONDON, GB<br>pages 1051 - 1054;<br>K. KAMATA ET AL: 'hybridization between si3n4 and sic films by plasma cvd'<br>* le document en entier *<br>--- | 1,2,14 | |
| A | US-A-5 017 403 (S.W. PANG)<br>* colonne 5 - colonne 6; tableaux I,II *<br>--- | 1,2,14 | |
| A | PATENT ABSTRACTS OF JAPAN<br>vol. 13, no. 134 (C-581)4 Avril 1989<br>& JP-A-63 297 208 ( NEC CORP. ) 5 Décembre 1988<br>* abrégé *<br>--- | 1,3,14 | |
| A | US-A-4 833 034 (L. MAYA)<br>* le document en entier *<br>--- | 1,5,9,14 | **DOMAINES TECHNIQUES RECHERCHES (Int. Cl.5)**<br><br>C23C |
| A | THIN SOLID FILMS<br>vol. 146, no. 1, Janvier 1987, LAUSANNE, CH<br>pages 93 - 107;<br>P. COUDERC ET AL: 'structure and physical properties of plasma-grown amorphous hydrogenated carbon films'<br>* page 94; tableau I *<br>--- | 1,5,14 | |
| A | JOURNAL OF APPLIED PHYSICS<br>vol. 65, no. 10, 15 Mai 1989, NEW YORK, USA<br>pages 3914 - 3918;<br>J.W. ZOU ET AL: 'THE DEPOSITION AND STUDY OF HARD CARBON FILMS'<br>* page 3914, alinéa II *<br>--- | 10 | |

Le présent rapport a été établi pour toutes les revendications

| Lieu de la recherche | Date d'achèvement de la recherche | Examinateur |
|---|---|---|
| LA HAYE | 28 JUILLET 1992 | JOFFREAU P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen
des brevets

**RAPPORT DE RECHERCHE EUROPEENNE**

Numero de la demande

EP    92 40 0941
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | APPLIED PHYSICS LETTERS vol. 58, no. 4, 28 Janvier 1991, NEW-YORK, USA pages 358 - 360; T.P. ONG ET AL: 'PROPERTIES OF DIAMOND COMPOSITE FILMS GROWN ON IRON SURFACES' * page 358, colonne 1, alinéa 2 -alinéa 3 * | 11 | |
| | | | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| LA HAYE | 28 JUILLET 1992 | JOFFREAU P. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)